# EUROPEAN PATENT SPECIFICATION

(11) **EP 4 529 365 B1**
(45) Date of publication and mention of the grant of the patent: **25.11.2026**
(21) Application number: 23890302.5
(22) Date of filing: 15.08.2023
(51) Int. Cl.: H05K 1/02, G06F 1/16, G09F 9/30, H04M 1/02

(54) **POSITIONING MECHANISM, FLEXIBLE PRINTED CIRCUIT, ASSEMBLY AND ELECTRONIC DEVICE**
POSITIONIERUNGSMECHANISMUS, FLEXIBLE LEITERPLATTE, ANORDNUNG UND ELEKTRONISCHE VORRICHTUNG
MÉCANISME DE POSITIONNEMENT, CIRCUIT IMPRIMÉ SOUPLE, ENSEMBLE ET DISPOSITIF ÉLECTRONIQUE

(30) Priority: 14.11.2022 CN 202211418193
(43) Date of publication of application: 26.03.2025
(73) Proprietor: Honor Device Co., Ltd., Shenzhen, Guangdong 518040 (CN)
(72) Inventor: CAO, Han, Shenzhen, Guangdong 518040 (CN); HOU, Yiwei, Shenzhen, Guangdong 518040 (CN); WANG, Wenhao, Shenzhen, Guangdong 518040 (CN); YANG, Xinrong, Shenzhen, Guangdong 518040 (CN); LI, Haifei, Shenzhen, Guangdong 518040 (CN)
(74) Representative: MERH-IP Matias Erny Reichl Hoffmann Patentanwälte PartG mbB
(86) International application number: PCT/CN2023/113033
(87) International publication number: WO 2024/103863

(56) References cited:
- EP-A1- 4 057 598
- CN-A- 102 064 404
- CN-A- 113 314 866
- CN-A- 115 126 768
- US-A- 6 096 986
- US-A1- 2011 044 013

## Description

This application claims priority to Chinese Patent Application No. 202211418193.3, filed with the China National Intellectual Property Administration on November 14, 2022 and entitled "POSITIONING MECHANISM, FLEXIBLE PRINTED CIRCUIT, FLEXIBLE PRINTED CIRCUIT ASSEMBLY, AND ELECTRONIC DEVICE'.

### TECHNICAL FIELD

This application relates to the field of electronic device technologies, and in particular, to a positioning mechanism, a flexible printed circuit, a flexible printed circuit assembly, and an electronic device.

### BACKGROUND

Currently, when a flexible printed circuit (flexible printed circuit, FPC) is applied to a foldable screen mobile phone, the FPC is usually fixed to a shaft cover of the foldable screen mobile phone by arranging a positioning mechanism. However, since a current positioning mechanism has a relatively large quantity of structures stacked in a Z direction, a relatively large space is occupied.

CN 115 126 768 A discloses a hinge mechanism including a rotating shaft assembly, a flexible circuit board (FCB), and a limiting member. The rotating shaft assembly has a cavity that partially houses the FCB, allowing it to bend during folding, while the limiting member fixes inside the cavity. Optionally, a fixing bracket further secures the FCB's fixing portion. The bracket uses a buckle structure that engages a buckle of the rotating shaft assembly for detachable installation.

US 2011/044013 A1 discloses a mobile phone including a housing with a base wall, opposite first and second sidewalls, and an end wall connecting the two sidewalls. The mobile phone further includes a PCB positioned at an opposite side of the housing. A first clip is mounted to the housing and secures a first FPCB to the PCB. The first sidewall defines a notch and includes a hook that latches with the first clip to hold it in place.

EP 4 057 598 A1 discloses a foldable device including a wire through an intermediate third housing between first and second housings, wherein a magnetic fastening assembly inside the third housing fixes the wire.

### SUMMARY

In view of this, this application provides a positioning mechanism, a flexible printed circuit, a flexible printed circuit assembly, and an electronic device, to optimize a structure of the positioning mechanism, as defined in the appended claims.

According to the embodiments of the present disclosure a positioning mechanism is provided, which is configured to be arranged on a base. The positioning mechanism includes at least two positioning members, arranged at intervals on the base along a length direction of the base; and a limiting member, arranged between the two positioning members, wherein each of the positioning members is provided with a clamping structure, two ends of the limiting member respectively extend to the clamping structures corresponding to the two positioning members, the clamping structure is configured to limit movement of the limiting member in a thickness direction of the base, and a flexible printed circuit is arranged between the limiting member and the base; wherein the positioning member comprises a positioning post, an end of the positioning post is fixed to the base, and an other end of the positioning post is provided with a protrusion extending toward the limiting member; wherein the clamping structure comprises a clamping groove, wherein the protrusion, the positioning post, and the base constitute the clamping groove, wherein two ends of the limiting member respectively extend into the clamping grooves corresponding to the two positioning members. Through comparison of the foregoing solution of examples of this application with the prior art, the flexible printed circuit is arranged between the limiting member and the base, and the movement of the limiting member in the thickness direction of the base is limited through the clamping structure. This simplifies mounting. Compared with the prior art, since a cover plate does not need to be arranged, fewer components are stacked in a Z direction, which reduces an occupied volume of the positioning mechanism and optimizes a structure of the positioning mechanism.

### BRIEF DESCRIPTION OF DRAWINGS

To describe the technical solutions in embodiments of this application or in the prior art more clearly, the accompanying drawings required for describing the embodiments or the prior art are to be briefly described below. Apparently, the accompanying drawings in the following description merely show some embodiments of this application, and a person of ordinary skill in the art may still derive other accompanying drawings based on the provided accompanying drawings without creative efforts.
FIG. 1A is a schematic diagram of a foldable screen mobile phone in an unfolded state according to the prior art;
FIG. 1B is a schematic diagram of a foldable screen mobile phone in a folded state according to the prior art;
FIG. 1C is a diagram showing an application scenario of an FPC in a foldable screen mobile phone according to the prior art;
FIG. 2 is a three-dimensional assembly view of an FPC, a positioning mechanism, and a shaft cover according to the prior art;
FIG. 3 is an exploded view of an FPC, a positioning mechanism, and a shaft cover according to the prior art;
FIG. 4 is a diagram showing an application scenario of an FPC in a foldable screen mobile phone according to an embodiment of this application;
FIG. 5 is a schematic diagram of a section in FIG. 4 taken along A-A;
FIG. 6 is a three-dimensional view of an FPC fixed to a shaft cover through a positioning mechanism according to an embodiment of this application;
FIG. 7 is an exploded view of an FPC, a positioning mechanism, and a shaft cover according to an embodiment of this application;
FIG. 8 is a front view of an FPC fixed to a shaft cover through a positioning mechanism according to an embodiment of this application;
FIG. 9 is a schematic diagram of a section in FIG. 8 taken along B-B;
FIG. 10 is a three-dimensional schematic diagram of a shaft cover, a positioning mechanism, and a reinforcing member according to an embodiment of this application from a specific perspective;
FIG. 11 is a three-dimensional schematic diagram of a shaft cover, a positioning mechanism, and a reinforcing member according to an embodiment of this application from another perspective;
FIG. 12 is schematic front view of a shaft cover, a positioning mechanism, and a reinforcing member according to an embodiment of this application;
FIG. 13 is a schematic diagram of a section in FIG. 12 taken along C-C;
FIG. 14A is an enlarged schematic view of a part D in FIG. 13 during mounting;
FIG. 14B is an enlarged schematic view of a part D in FIG. 13;
FIG. 15 is a three-dimensional view of an FPC according to an embodiment of this application;
FIG. 16 is a front view of an FPC according to an embodiment of this application; and
FIG. 17 is a schematic diagram of a section in FIG. 16 taken along E-E.
1. First housing, 2. Second housing, 3. Shaft cover, 4. FPC, 5. Positioning mechanism; 41. First FPC, 42. Second FPC, 43. First reinforcing member, 44. Second reinforcing member, 43a. First end, 43b. Second end, 43a1. First limiting portion, 43a2. First protruding portion, 43a3. Second limiting portion, 43b. First end, 43b. Second end, 43b1. Third limiting portion, 43b2. Second protruding portion, 43b3. Fourth limiting portion, 44a. First end, 44b. Second end, 51. First positioning post, 52. Second positioning post, 53. Third positioning post, 54. Fourth positioning post, 55. First back adhesive, 56. Second back adhesive, 57. First protective member, 58. Second protective member.

### DESCRIPTION OF EMBODIMENTS

Terms "first", "second", "third", and the like in the specification, claims, and accompanying drawings of this application are used to distinguish between different objects rather than to limit a specific order.

In embodiments of this application, a term such as "in an example" or "for example" is used to represent giving an example, an illustration, or a description. Any embodiment or design solution described as "in an example" or "for example" in embodiments of this application should not be explained as being more preferred or having more advantages than another embodiment or design solution. Exactly, use of the term such as "in an example" or "for example" is intended to present a related concept in a specific manner.

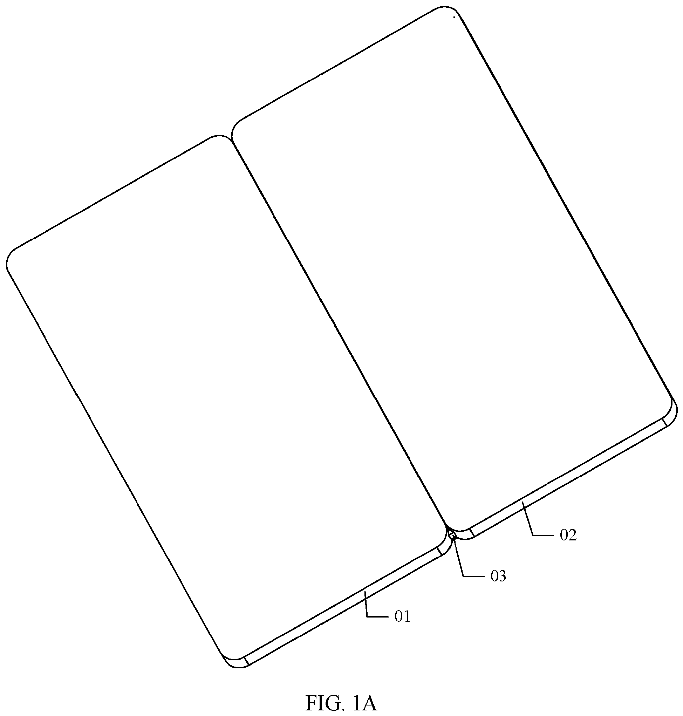

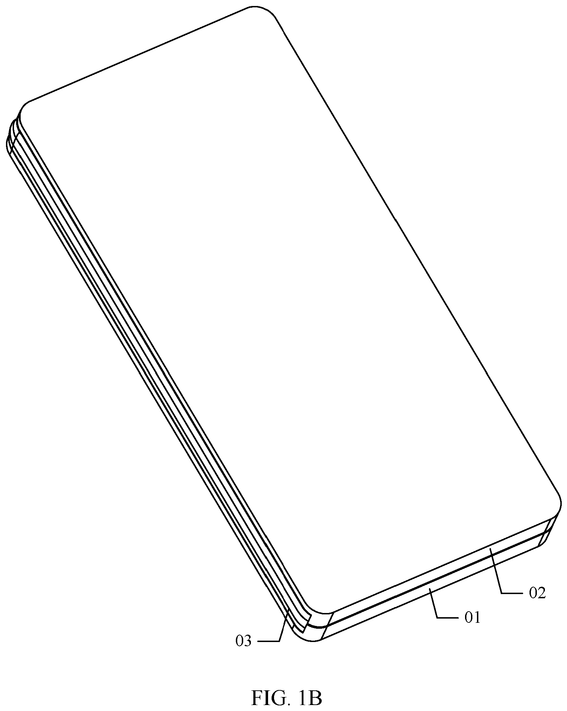

A mobile phone is used as an example. For example, FIG. 1A shows a foldable screen mobile phone in an unfolded state. FIG. 1B shows a foldable screen mobile phone in a folded state. The foldable screen mobile phone shown in the figures includes a first housing 01 and a second housing 02. The first housing 01 and the second housing 02 may be unfolded or folded around a rotating shaft assembly 03.

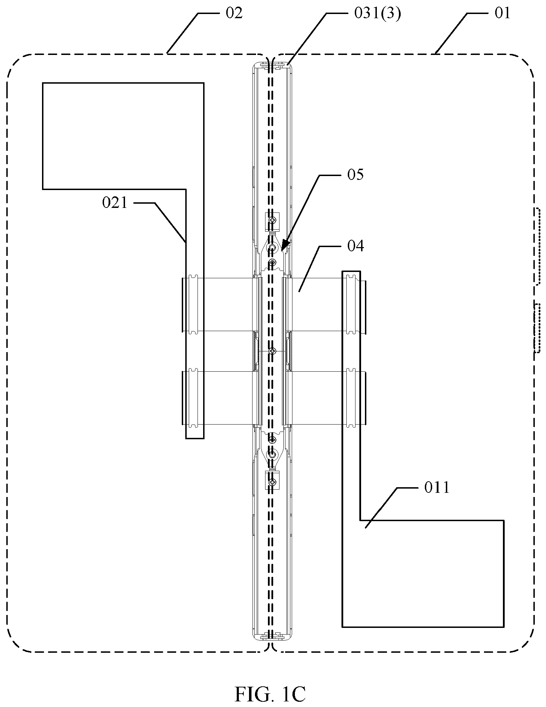

As shown in FIG. 1C, in the foldable screen mobile phone, a flexible printed circuit (flexible printed circuit, FPC) is usually used to connect a main circuit board 011 and an auxiliary circuit board 021 on two sides of the rotating shaft assembly 03, to implement transmission of signals and energy. During mounting of an FPC 04, a positioning mechanism is required to fix the FPC 04 to the rotating shaft assembly 03. A specific space is required for arrangement of a positioning mechanism 05, and the rotating shaft assembly 03 needs a space to implement a function thereof and ensure strength thereof. Therefore, it is particularly necessary to design the positioning mechanism of the FPC as small as possible.

It should be noted that the figure merely illustrates a general positional relationship among the first housing 01, the second housing 02, the rotating shaft assembly 03, the FPC 04, and the positioning mechanism 05 in the foldable screen mobile phone. The first housing 01 and the second housing 02 are respectively located on two sides of the rotating shaft assembly 03. An end of the FPC 04 is connected to the main circuit board 011 located inside the first housing 01, and an other end of the FPC is connected to the auxiliary circuit board 021 located inside the second housing 02. A middle portion of the FPC 04 is fixed to a shaft cover 031 of the rotating shaft assembly 03 through the positioning mechanism 05.

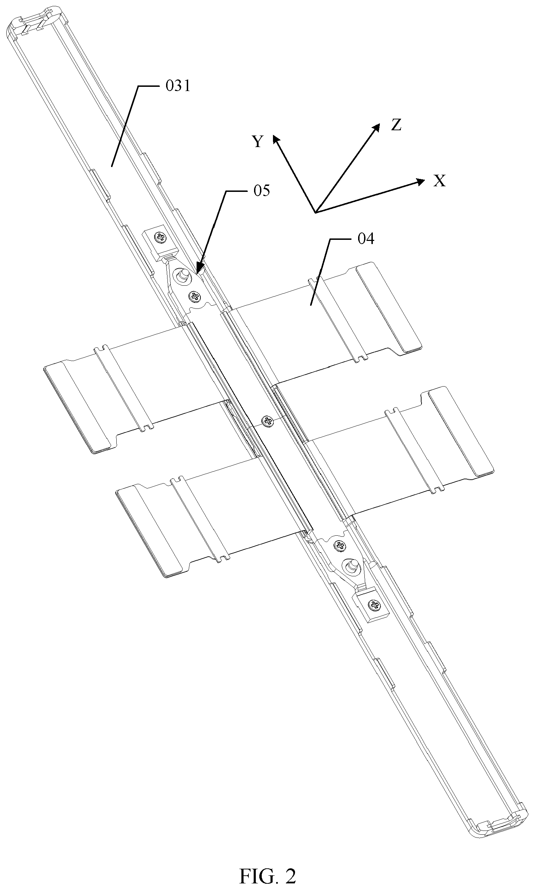

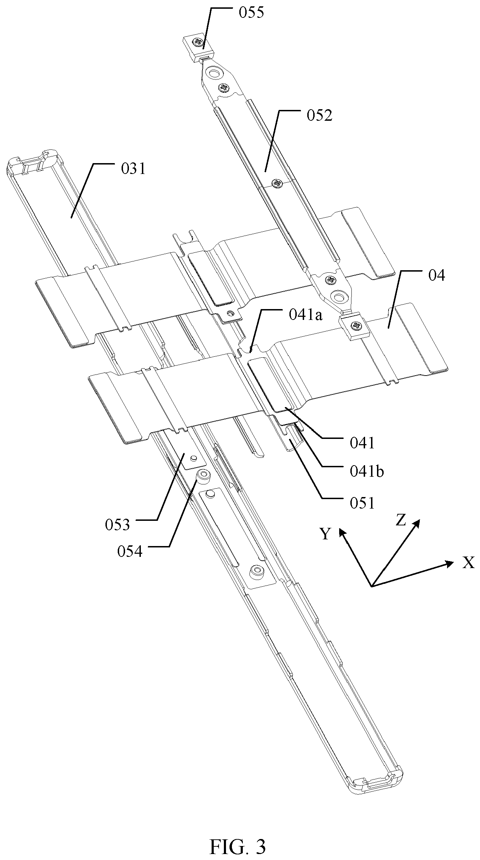

As shown in FIG. 2 and FIG. 3, FIG. 2 is a three-dimensional view of the FPC 04 fixed to the shaft cover 031 through the positioning mechanism 05 in the prior art, and FIG. 3 is an exploded view of the FPC 04, the positioning mechanism 05, and the shaft cover 031 in the prior art. The positioning mechanism 05 in the figure includes a support 051, a cover plate 052, a back adhesive 053, and a pressing block 055. The support 051 is arranged below the FPC 04 and adhered to the shaft cover 03 through the back adhesive 053. The cover plate 052 is arranged above the FPC 04, and is locked on the shaft cover 031 by screws. To improve connection strength between the cover plate 052 and the shaft cover 031, a pressing block 055 is arranged on each of two ends of the cover plate 052, and the cover plate is further fixed to the shaft cover 031 through the pressing blocks 055. With the dual cooperation of the back adhesive 053 and the cover plate 052, fixation and positioning of the FPC 04 in a Z direction are implemented. A notch 041a at a first end and a notch 041b at a second end of a reinforcing member 041 of the FPC 04 are mated with a positioning post 054 on the shaft cover 031, to implement fixation and positioning of the FPC 04 in an X direction and a Y direction. The X direction, the Y direction, and the Z direction are perpendicular to each other. However, during mounting of the positioning mechanism 05 of the foregoing structure, screws need to be arranged for both the cover plate 052 and the pressing block 055 to realize the connection between the cover plate 052 and the shaft cover 031. For the connection between the pressing block 055 and the shaft cover 031, a relatively large quantity of mounting processes are required, and an additional structure for mating with the screws needs to be arranged. In addition, structures stacked in the Z direction include the back adhesive 053, the FPC, and the cover plate 052, or the support 051, the FPC, and the cover plate 052. In other words, a relatively large quantity of structures stacked in the Z direction occupy space in the Z direction. This is inconsistent with a requirement for a miniaturized design of the positioning mechanism 05.

Based on this, this application provides an electronic device, an FPC assembly, an FPC, and a positioning mechanism, to optimize the structure.

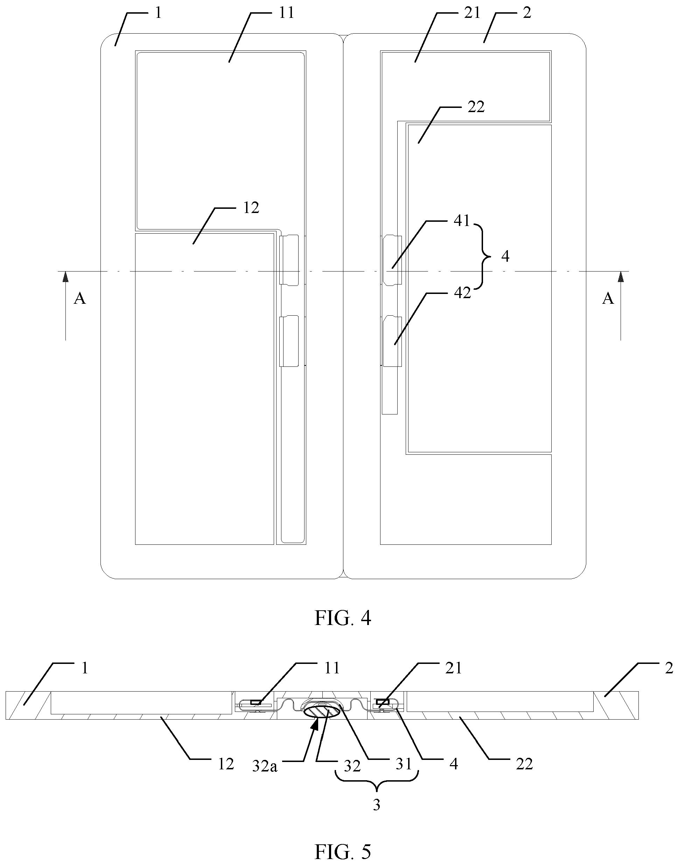

As shown in FIG. 4 and FIG. 5, FIG. 4 is a diagram showing an application scenario of an FPC in a foldable screen mobile phone. The figure merely illustrates a general positional relationship among a first housing 1, a second housing 2, a rotating shaft assembly 3, an FPC 4, and a positioning mechanism 5 in the foldable screen mobile phone. The first housing 1 and the second housing 2 are respectively located on two sides of the rotating shaft assembly 3. An end of the FPC 4 bypasses and is electrically connected to a main circuit board 11 located inside the first housing 1, and an other end of the FPC 4 bypasses and is electrically connected to an auxiliary circuit board 21 located inside the second housing 2. A middle portion of the FPC 4 is fixed to the rotating shaft assembly 3 through the positioning mechanism 5.

A part of the FPC 4 located in the first housing 1 is fixed to a middle frame 12 of the first housing 1, and a part of the FPC 4 located in the second housing 2 is fixed to a middle frame 22 of the second housing 2. The middle frame 12 is configured to form a mounting plate or a mounting groove in the first housing 1, and the middle frame 22 is configured to form a mounting plate or a mounting groove in the second housing 1.

The rotating shaft assembly 3 includes a rotating shaft 32. The rotating shaft 32 is a core component for realizing unfolding or folding of the first housing 1 and the second housing 2. An end surface of the rotating shaft 32 has a folded region 32a, and the rotating shaft 32 may be folded or unfolded around the folded region 32a. The rotating shaft assembly 3 further includes a shaft cover 31. The shaft cover 31 is arranged on an end surface of the rotating shaft 32 opposite to the folded region 32a. In an example of this application, the positioning mechanism 5 may be arranged on the rotating shaft 32 of the rotating shaft assembly 3, may be further arranged on the shaft cover 31 of the rotating shaft assembly 3, may be further arranged on the middle frame 12, and may be further arranged on the middle frame 22. In this application, the shaft cover 31, the rotating shaft 32, and/or the middle frame 12, 22 configured to arrange the positioning mechanism 5 may be understood as the base, and the FPC can be fixed to a specific part by arranging the positioning mechanism 5. This application focuses on description of a structure of the positioning mechanism 5 arranged on the shaft cover 31.

It should be noted that the figure illustrates a case in which two FPCs 4 are arranged, including a first FPC 41 and a second FPC 42. Certainly, one FPC 4 may be further arranged.

The foldable screen mobile phone of this application is used as an electronic device. The foregoing electronic device may further be a mobile terminal device having a battery, for example, a non-foldable screen mobile phone other than the foldable screen mobile phone, a tablet computer (portable android device, PAD), a desktop computer, a laptop computer, a notebook computer, an ultra-mobile personal computer (Ultra-mobile Personal Computer, UMPC), a handheld computer, a netbook, a personal digital assistant (Personal Digital Assistant, PDA), a wearable electronic device, or a smart watch. A form of the electronic device is not specifically limited in embodiments of this application.

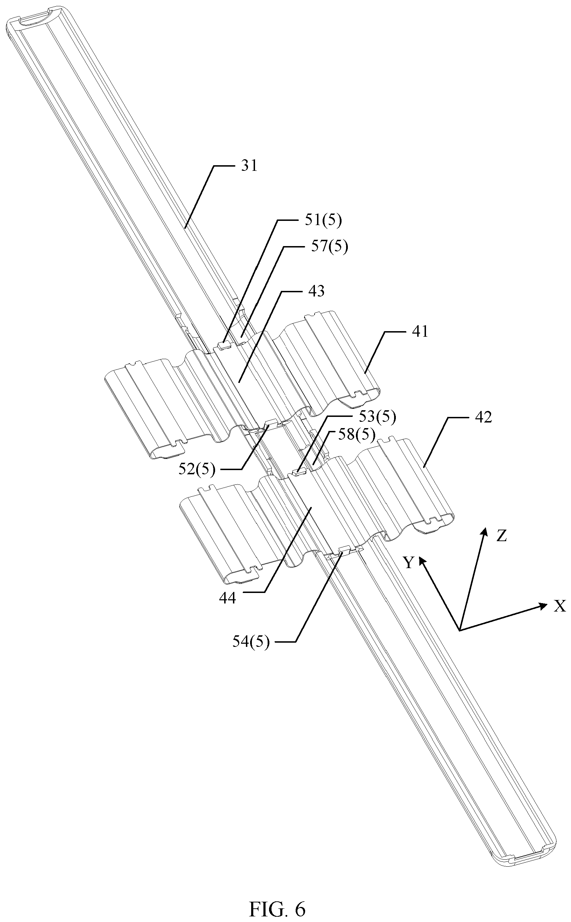

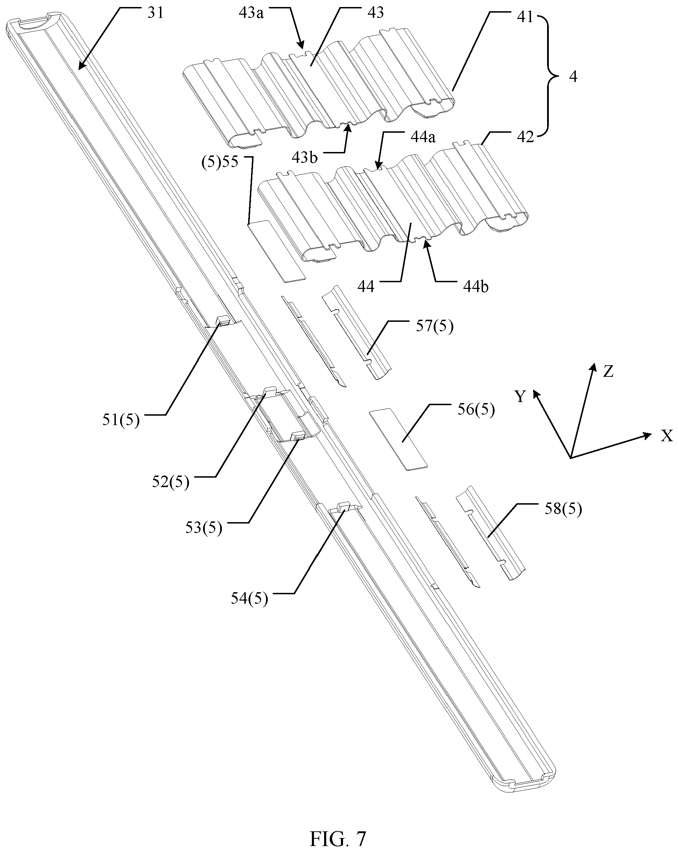

Refer to FIG. 6. FIG. 6 is a three-dimensional view of an FPC fixed to a shaft cover through a positioning mechanism according to an embodiment of this application, and FIG. 7 is an exploded view of an FPC, a positioning mechanism, and a shaft cover according to an embodiment of this application. Two FPCs 4 shown in the figure are arranged, including a first FPC 41 and a second FPC 42. The first FPC 41 is provided with a first reinforcing member 43, and the second FPC 42 is provided with a second reinforcing member 44. The first reinforcing member 43 exists as a self-contained structure of the first FPC 41, to improve mechanical strength of a local mounting part of the first FPC 41. The second reinforcing member 44 exists as a self-contained structure of the second FPC 42, to improve mechanical strength of a local mounting part of the second FPC 42.

To reduce a risk of cracking between the FPC and the reinforcing member, in some examples of this application, the first reinforcing member 43 is arranged on a surface of the first FPC 41 away from the shaft cover 31. When the first FPC 41 is subjected to an external force, the first reinforcing member 43 is first stressed, thereby reducing the risk of cracking between the first FPC 41 and the first reinforcing member 43. Similarly, the second reinforcing member 44 is arranged on a surface of the second FPC 42 away from the shaft cover 31.

The positioning mechanism 5 shown in the figure includes a first positioning post 51, a second positioning post 52, a third positioning post 53, a fourth positioning post 54, a first back adhesive 55, a second back adhesive 56, a first protective member 57, a second protective member 58, a first reinforcing member 43, and a second reinforcing member 44. The first positioning post 51, the second positioning post 52, the first back adhesive 55, and the first protective member 57 are configured to fix the first FPC 41. The third positioning post 53, the fourth positioning post 54, the second back adhesive 56, and the second protective member 58 are configured to fix the second FPC 42.

Specifically, the first protective member 57 and the first back adhesive 55 are arranged below the first FPC 41, and are adhered to the shaft cover 31 through the first back adhesive 55. A first end 43a of the first reinforcing member 43 is mated with the first positioning post 51, and a second end 43b of the first reinforcing member 43 is mated with the second positioning post 52. In addition, the first reinforcing member 43 is clamped between the first positioning post 51 and the second positioning post 52 when being mounted in place between the first positioning post 51 and the second positioning post 52, to limit movement of the first steel reinforcement 43 in an X direction, a Y direction, and a Z direction.

The second protective member 58 and the second back adhesive 56 are arranged below the second FPC 42, and are adhered to the shaft cover 31 through the second back adhesive 56. A first end 44a of the second reinforcing member 44 is mated with the third positioning post 53, and a second end 44b of the second reinforcing member 44 is mated with the fourth positioning post 54. In addition, the second reinforcing member 44 is clamped between the third positioning post 53 and the fourth positioning post 54 when being mounted in place between the third positioning post 53 and the fourth positioning post 54, to limit movement of the second steel reinforcement 44 in the X direction, the Y direction, and the Z direction.

It should be noted that the X direction, the Y direction, and the Z direction are perpendicular to each other. In the figure, the X direction corresponds to a width direction of the shaft cover 31, the Y direction corresponds to a length direction of the shaft cover 31, and the Z direction corresponds to a thickness direction of the shaft cover 31.

It may be learned that the structures stacked in the Z direction in the foregoing embodiments of the examples of this application include the back adhesive and the FPC 4, or the protective member and the FPC 4. Compared with the prior art, the FPC 4 may be directly clamped between the positioning posts through the reinforcing member (the first FPC 41 may be directly clamped between the first positioning post 51 and the second positioning post 52 through the first reinforcing member 43, and the second FPC 42 may be directly clamped between the third positioning post 53 and the fourth positioning post 54 through the second reinforcing member 44). The mounting is simple and convenient. In addition, since the reinforcing member is the structure of the FPC (the first reinforcing member 43 is the structure of the first FPC 41, and the second reinforcing member 44 is the structure of the second FPC 42), no additional cover plate is required. Fewer components are stacked in the Z direction, which reduces an occupied volume and a weight of the positioning mechanism 5 and optimizes the structure of the positioning mechanism 5.

In the foregoing example of this application, the first protective member 57 is configured to protect the first FPC 41 and prevent processing defects such as burrs and flashes of the shaft cover 31 from scratching the first FPC 41. The second protective member 58 is configured to protect the second FPC 42 and prevent the processing defects such as burrs and flashes of the shaft cover 31 from scratching the second FPC 42.

In the example of this application, two first protective members 57 may be arranged. The two first protective members 57 are each laid on a part of the shaft cover 31 close to a side edge in the X direction, and are respectively located on two sides of the first back adhesive 55. In some other examples of this application, one first protective member 57 may be arranged. The one first protective member 57 surrounds a periphery of the first back adhesive 55, and extends to the part of the shaft cover 31 close to the side edge. Certainly, in another example of this application, another quantity of first protective members 57 may be further arranged, as long as protective performance of key parts of the first FPC 41 and the shaft cover 31 can be implemented.

Similarly, two second protective members 58 may be arranged. The two second protective members 58 are each laid on the part of the shaft cover 31 close to the side edge in the X direction, and are respectively located on two sides of the second back adhesive 56. In some other examples of this application, one second protective member 58 may be arranged. The one second protective member 58 surrounds a periphery of the second back adhesive 56, and extends to the part of the shaft cover 31 close to the side edge. Certainly, in another example of this application, another quantity of second protective members 58 may be further arranged, as long as protective performance of key parts of the second FPC 42 and the shaft cover 31 can be implemented.

**In** some examples of this application, the first protective member 57 and the second protective member 58 described above are independent components, and are arranged at corresponding parts of the shaft cover 31 in the foregoing manner. In some examples of this application, the first protective member 57 and the second protective member 58 are formed as an integral structure, which surround the periphery of the first back adhesive 55 and the periphery of the second back adhesive 56, and extend to the parts of the shaft cover 31 close to the side edge.

The first protective member 57 and the second protective member 58 include a sheet structure made of an insulating material. The foregoing insulating material may be, for example, non-metallic mylar. Common materials of the non-metallic mylar include polycarbonate (PC), polyterephthalate plastic (PET, Polyethyleneterephthalate), Teflon (PTFE, Polytetrafluoroethene), and the like. Preferably, Teflon mylar is selected. Teflon, also referred to as polytetrafluoroethylene, is a synthetic polymer material that uses fluorine to replace all hydrogen atoms in polyethylene. Teflon has characteristics of acid resistance, alkali resistance, resistance to various organic solvents, and is almost insoluble in all solvents. In addition, polytetrafluoroethylene has a characteristic of resistance to high temperatures, and has an excessively small friction coefficient, which may be therefore used as a lubricant and also becomes an ideal coating for non-stick pans and water pipe lining. The first protective member 57 and the second protective member 58 include Teflon mylar, which may reduce friction noise generated during the movement of the first FPC 41 and/or the second FPC 42 relative to the shaft cover 31.

In some other examples of this application, the first protective member 57 and the second protective member 58 include a coating structure applied to an end surface of the shaft cover 31. Preferably, the coating structure is a Teflon coating.

In an example of this application, the first back adhesive 55 and the second back adhesive 56 may be an adhesive, a double-sided adhesive, a foam adhesive, and the like. The first FPC 41 and the second FPC 42 are positioned in the Z direction. The first back adhesive 55 and the second back adhesive 56 may be further adjusted to be insulating or conductive as required, to ensure insulating performance or electrical conductivity between the first FPC 41 and the shaft cover 31 at a position where the first back adhesive 55 is arranged, and insulating performance or electrical conductivity between the second FPC 42 and the shaft cover 31 at a position where the second back adhesive 56 is arranged.

In the foregoing example of this application, the positioning mechanism 5 includes a solution of the first protective member 57, the second protective member 58, the first back adhesive 55, and the second back adhesive 56. In some other examples of this application, the positioning mechanism 5 includes a solution of the first protective member 57 and the second protective member 58, that is, does not include a solution of the first back adhesive 55 and the second back adhesive 56. The first protective member 57 is laid at a position of the shaft cover 31 corresponding to the first FPC 41, and the second protective member 58 is laid at a position of the shaft cover 31 corresponding to the second FPC 42.

A structure for positioning the first FPC 41 in the positioning mechanism 5 is similar to a structure for positioning the second FPC 42. The following examples of this application focus on description of the structure for positioning the first FPC 41.

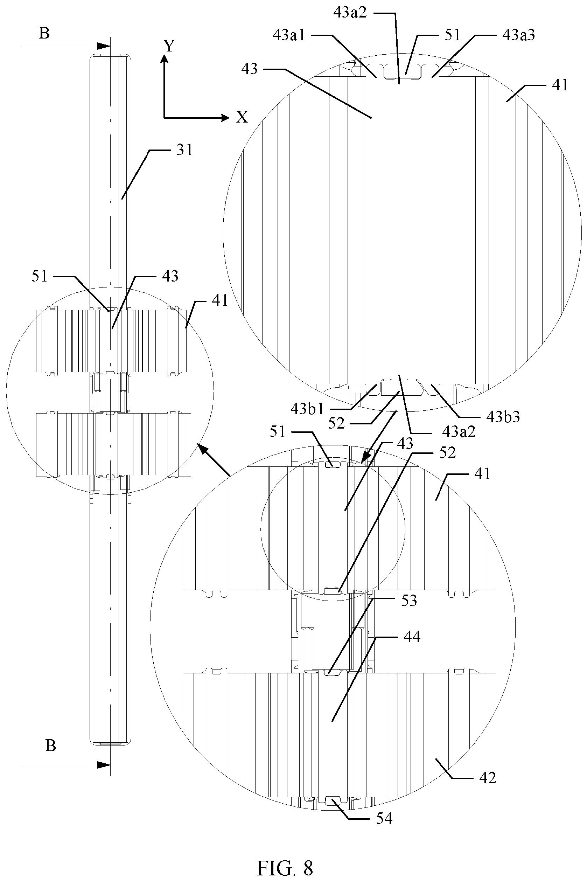

Refer to FIG. 8. A first positioning post 51 and a second positioning post 52 are arranged at intervals along a Y direction, and a first reinforcing member 43 is mounted between the first positioning post and the second positioning post. A first limiting portion 43a1 and a second limiting portion 43a3 are arranged at intervals on a first end 43a of the first reinforcing member 43. A region between the first limiting portion 43a1 and the second limiting portion 43a3 forms a first notch for accommodating at least part of the first positioning post 51. A first protruding portion 43a2 protrudes from a notch wall of the first notch toward the first positioning post 51. The first protruding portion 43a2 is snap-fitted to a surface of the first positioning post 51 opposite to the second positioning post 52. A third limiting portion 43b1 and a fourth limiting portion 43b3 are arranged at intervals on a second end 43b of the first reinforcing member 43. The third limiting portion 43b1 and the fourth limiting portion 43b3 form a second notch for accommodating at least part of the second positioning post 52. A second protruding portion 43b2 protrudes from a notch wall of the second notch toward the first positioning post 51. The second protruding portion 43b2 is snap-fitted to a surface of the second positioning post 52 opposite to the first positioning post 51. It may be seen that the first reinforcing member 43 is between the first positioning post 51 and the second positioning post 52, so as to limit movement of the first reinforcing member 43 in the Y direction. At least part of the first positioning post 51 is located in the first notch, and at least part of the second positioning post 52 is located in the second notch, thereby limiting movement of the first end 43a and the second end 43b of the first reinforcing member 43 in the X direction. The first reinforcing member 43 has specific elastic resilience. After the first protruding portion 43a2 is snap-fitted to the first positioning post 51, and the second protruding portion 43b2 is snap-fitted to the second positioning post 52, the movement of the first reinforcing member 43 in the Z direction is limited by a snap fit of the two ends of the first reinforcing member 43. It may be seen that the structure is optimized through the example of this application. In addition, relatively few adaptive adjustments are made to a tool path and a mold structure for processing the shaft cover 31, thereby shortening a development cycle.

A contour of the first positioning post 51 located in the first notch matches a contour of the first notch. A projection (a section) of the first positioning post 51 on a plane where XY is located is generally shaped like a rectangle, and a projection (a section) of the second positioning post 52 on a plane where XY is located is generally shaped like a trapezoid. However, the first notch mated with the first positioning post 51 is generally shaped like a rectangle, and the second notch mated with the second positioning post 52 is generally shaped like a trapezoid. The first end of the first reinforcing member 43 can only be assembled to the first positioning post 51, and the second end of the first reinforcing member 43 can only be assembled to the second positioning post 52. In this way, the first reinforcing member 43 can be mounted in place. Such arrangement can implement a purpose of error prevention (preventing a mounting error). In the example of this application, an effect of error prevention can be achieved by arranging different sectional shapes and notch shapes. In still some examples of this application, a sectional shape of the first positioning post 51 may be further the same as a sectional shape of the second positioning post 52. Similarly, a shape of the first notch may be further the same as a shape of the second notch.

A contour of the second positioning post 52 located in the second notch matches a contour of the second notch. The sectional shape of the first positioning post 51 in the figure is generally shaped like a rectangle. Certainly, the sectional shape may be alternatively a relatively regular shape such as a circle, an ellipse, or a trapezoid, or may be an irregular shape. In this application, the rectangular structure is preferably adopted, which has low processing difficulty and is conducive to processing and formation.

The sectional shape of the second positioning post 52 in the figure is generally shaped like a trapezoid, for example, an isosceles trapezoid or a right-angled trapezoid in the trapezoid, may be alternatively a relatively regular shape such as a circle, an ellipse, or a rectangle, or may be an irregular shape. In this application, a right-angled trapezoidal structure is preferably adopted, which is easy for processing and formation based on the rectangular structure, and has little improvement of the tool path.

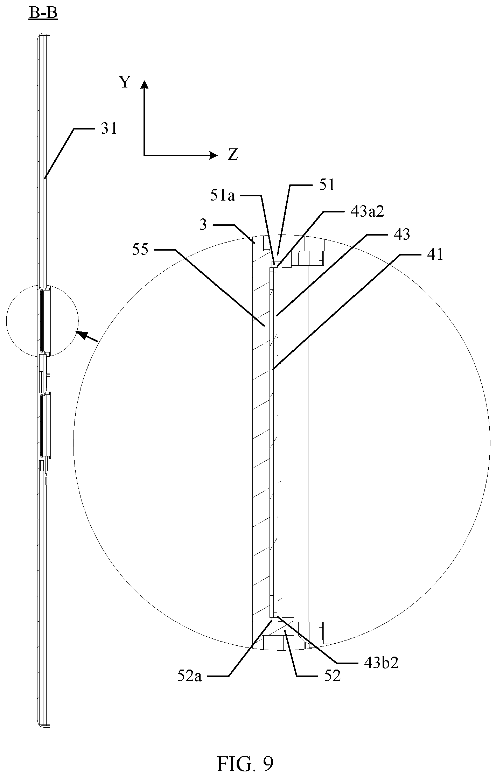

Refer to FIG. 9. A first clamping groove 51a is provided on a surface of a first positioning post 51 opposite to a second positioning post 52, to mate with a first protruding portion 43a2 of a first reinforcing member 43. The first clamping groove 51a is provided with a top wall and a bottom wall arranged opposite to the top wall in a Z direction, and the top wall of the first clamping groove 51a can abut against the first protruding portion 43a2. When an external force in the Z direction is applied to the first reinforcing member 43, the top wall of the first clamping groove 51a abuts against the first protruding portion 43a2 to prevent the first protruding portion 43a2 from being disengaged from the first clamping groove 51a in the Z direction. A second clamping groove 52a is provided on a surface of the second positioning post 52 opposite to the first positioning post 51, to mate with a second protruding portion 43b2 of the first reinforcing member 43. A top wall of the second clamping groove 52a can abut against the second protruding portion 43b2 in the Z direction. When an external force in the Z direction is applied to the first reinforcing member 43, the top wall of the first clamping groove 51a abuts against the second protruding portion 43b2 to prevent the second protruding portion 43b2 from being disengaged from the second clamping groove 52a in the Z direction.

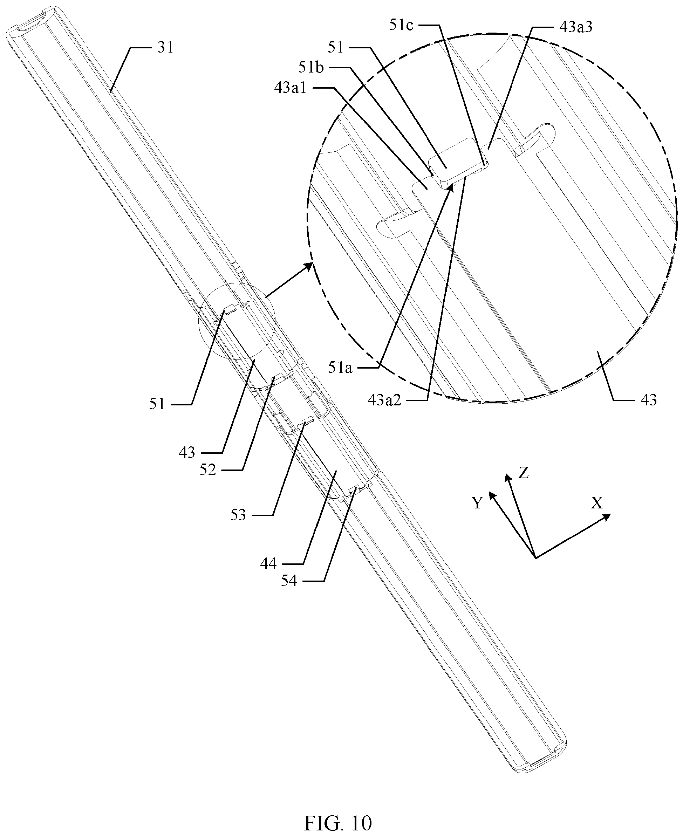

Refer to FIG. 10. In an X direction, two ends of a first clamping groove 51a are not run-through. In other words, the first clamping groove 51a is provided with a first side wall 51b and a second side wall 51c. The first side wall 51b and the second side wall 51c are arranged opposite to each other. The first side wall 51b and the second side wall 51c of the first clamping groove 51a may abut against a first protruding portion 43a2. When an external force in the X direction is applied to a first reinforcing member 43, the first side wall 51b of the first clamping groove 51a or the second side wall 51c of the first clamping groove 51a abuts against the first protruding portion 43a2, thereby limiting movement of the first protruding portion 43a2 in the X direction.

In an example of this application, a top wall of the first clamping groove 51a can limit the movement of the first protruding portion 43a2 in a Z direction, and the side wall of the first clamping groove 51a can limit the movement of the first protruding portion 43a2 in the X direction. It may be learned from the above example that mating of a first notch formed by a first limiting portion 43a1 and a second limiting portion 43a3 with the first positioning post 51 can limit the movement of the first reinforcing member 43 in the X direction. Therefore, in still some examples of this application, only the first clamping groove 51a and the first protruding portion 43a2 may be alternatively provided, and the first limiting portion 43a1 and the second limiting portion 43a3 are not arranged, so as to limit the movement of the first reinforcing member 43 in the X direction and the Y direction.

It should be noted that an end of the first positioning post 51 is fixed to a shaft cover 31, and an other end extends along the Z direction. The first clamping groove 51a is directly provided on a surface of the first positioning post 51 opposite to a second positioning post 52. Alternatively, an other end of the first positioning post 51 is provided with a first protrusion protruding toward the second positioning post 52. The first protrusion, the first positioning post 51, and the shaft cover 31 jointly constitute the first clamping groove 51a.

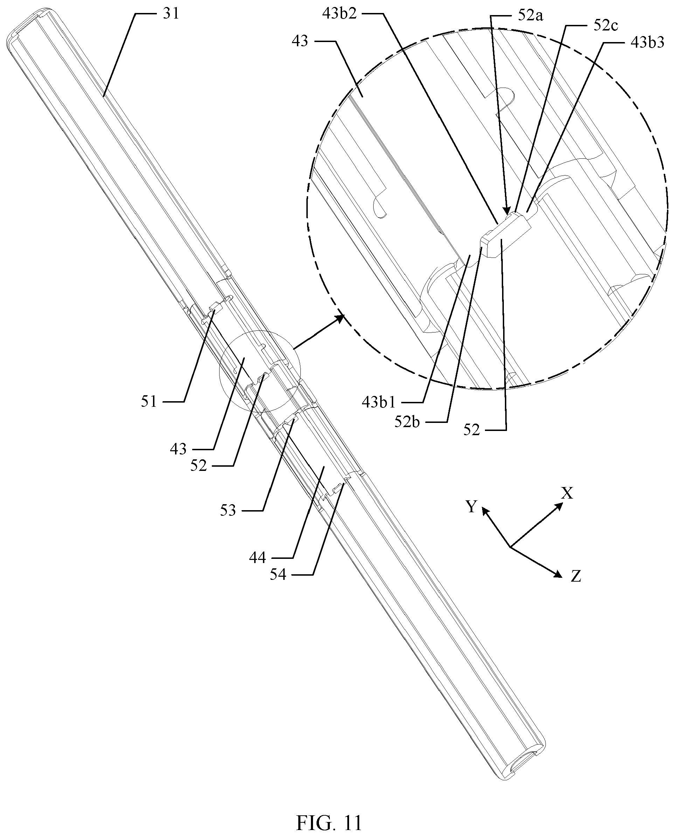

Refer to FIG. 11. In an X direction, two ends of a second clamping groove 52a are not run-through. In other words, the second clamping groove 52a is provided with a first side wall 52b and a second side wall 52c. The first side wall 52b and the second side wall 52c are arranged opposite to each other. The first side wall 52b and the second side wall 52c of the second clamping groove 52a may abut against a second protruding portion 43b2. When an external force in the X direction is applied to a first reinforcing member 43, the first side wall 52b of the second clamping groove 52a or the second side wall 52c of the second clamping groove 52a abuts against the second protruding portion 43b2, thereby limiting movement of the second protruding portion 43b2 in the X direction.

In an example of this application, a top wall of the second clamping groove 52a can limit the movement of the second protruding portion 43b2 in a Z direction, and the side wall of the second clamping groove 52a can limit the movement of the second protruding portion 43b2 in the X direction. It may be learned from the above example that mating of a second notch formed by a third limiting portion 43b1 and a fourth limiting portion 43b3 with the second positioning post 52 can limit the movement of the first reinforcing member 43 in the X direction. Therefore, in still some examples of this application, only the second clamping groove 52a and the second protruding portion 43b2 may be alternatively provided, and the third limiting portion 43b1 and the fourth limiting portion 43b3 are not arranged, so as to limit the movement of the first reinforcing member 43 in the X direction and the Y direction.

It should be noted that an end of the second positioning post 52 is fixed to a shaft cover 31, and an other end extends along the Z direction. The second clamping groove 52a is directly provided on a surface of the second positioning post 52 opposite to a first positioning post 51. Alternatively, an other end of the second positioning post 52 is provided with a second protrusion protruding toward the first positioning post 51. The second protrusion, the second positioning post 52, and the shaft cover 31 jointly constitute the second clamping groove 52a.

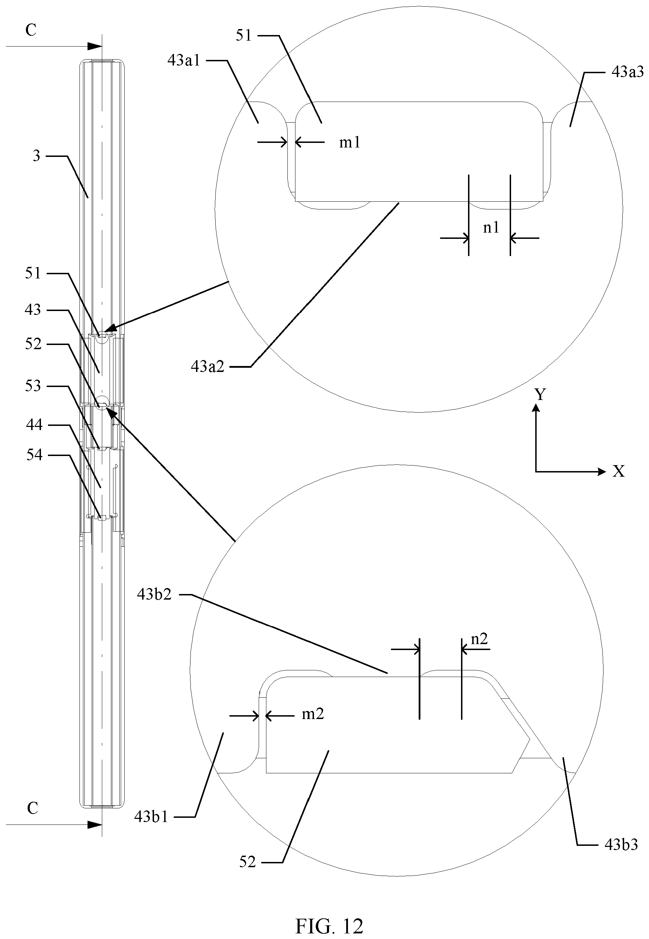

With reference to FIG. 10 and FIG. 11, referring to FIG. 12, in some examples of this application, a first end 43a of a first reinforcing member 43 is mated with a first positioning post 51 through a first notch, thereby realizing positioning of the first end of the first reinforcing member 43 in an X direction and a Y direction. A first positioning gap m1 is defined between the first notch and the first positioning post 51, so that the first notch can be smoothly mounted to the first positioning post 51, to ensure positioning precision of the first notch and the first positioning post. A second end 43b of a second reinforcing member 44 is mated with a second positioning post 52 through a second notch, thereby realizing positioning of the second end 43b of the first reinforcing member 43 in the X direction and the Y direction. A second positioning gap m2 is defined between the second notch and the second positioning post 52, so that the second notch can be smoothly mounted to the second positioning post 52, to ensure positioning precision of the second notch and the second positioning post.

It should be noted that the first positioning gap m1 is a vertical distance between an inner surface of the first notch and a part corresponding to an outer surface of the first positioning post 51. In the figure, if a section of the first positioning post 51 and the first notch are both shaped like a rectangle, the first positioning gap m1 is a vertical distance between corresponding sides of the two rectangles. The second positioning gap m2 is a vertical distance between an inner surface of the second notch and a part corresponding to an outer surface of the second positioning post 52. In the figure, if a section of the second positioning post 52 and the second notch are both shaped like a right-angled trapezoid, the second positioning gap m2 is a vertical distance between corresponding sides of the two right-angled trapezoids.

To improve precision of the first reinforcing member 43 during mounting, the first positioning gap m1 and the second positioning gap m2 ranges from 0.03 mm to 0.1 mm, and are preferably 0.05 mm. In other words, positioning precision of the first notch of the first reinforcing member 43 and the first positioning post 51 is ensured, and positioning precision of the second notch of the first reinforcing member 43 and the second positioning post 52 is ensured. When the first reinforcing member 43 is mounted in place between the first positioning post 51 and the second positioning post 52, a margin for movement exists between the first notch and the first positioning post 51, and a margin for movement exists between the second notch and the second positioning post 52, thereby ensuring that a margin for movement exists between the first reinforcing member 43 in the X direction and the Y direction. When an external force in the X direction and/or the Y direction is applied to the first reinforcing member 43, a specific buffer space exists, which reduces strength of rigid pulling.

Further, in the X direction, a first avoidance gap n1 is defined between the first clamping groove 51a and the first protruding portion 43a2. By providing the first avoidance gap n1, the first notch can be arranged on the first positioning post 51. Similarly, a second avoidance gap n2 is defined between the second clamping groove 52a and the second protruding portion 43b2. By providing the second avoidance gap n2, the second notch can be arranged on the second positioning post 52. It should be noted that the foregoing first avoidance gap n1 is a distance between the first protruding portion 43a2 and each of the first side wall 51b and the second side wall 51c of the first clamping groove 51a in the X direction. The foregoing second avoidance gap n2 is a distance between the first protruding portion 43a2 and each of the first side wall 52b and the second side wall 52c of the second clamping groove 52a in the X direction.

The foregoing first avoidance gap n1 is greater than the first positioning gap m1, and/or the second avoidance gap n2 is greater than the second positioning gap m1, thereby preventing the FPC from being skewed and implementing reliable positioning and fixation in the X direction and the Y direction.

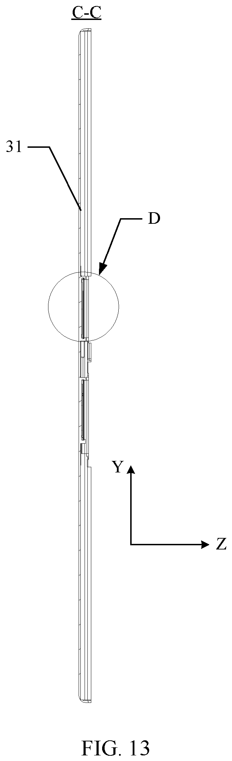

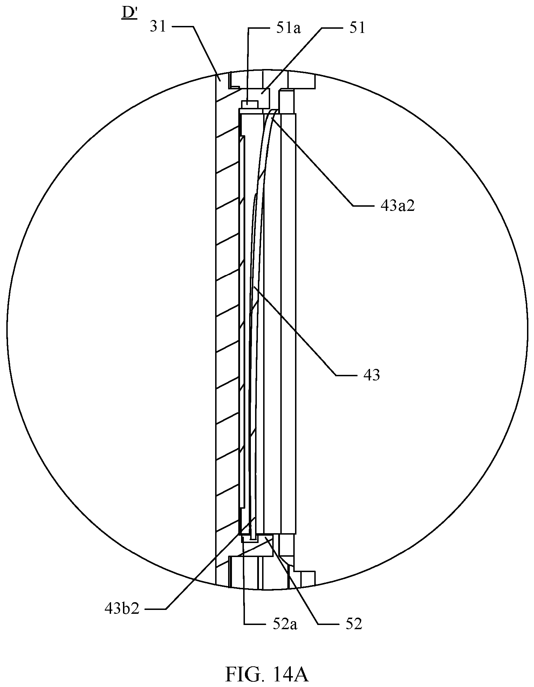

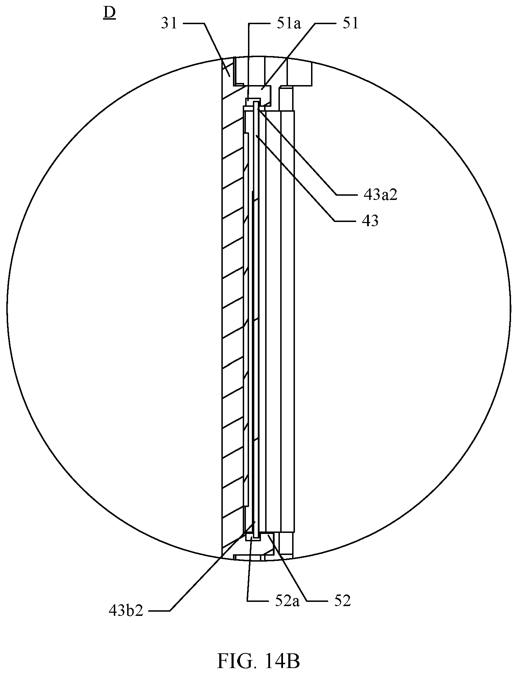

Refer to FIG. 13, FIG. 14A, and FIG. 14B. A first protruding portion 43a2 on a first reinforcing member 43 interferes with a first positioning post 51, and a second protruding portion 43b2 interferes with a second positioning post 52 in a Y direction. Therefore, the second protruding portion 43b2 needs to be obliquely inserted into a first clamping groove 51a during assembly. The first reinforcing member 43 is used as an elastic arm for the first protruding portion 43a2 for an entire length for which reinforcement is applied, to reduce the length of the first reinforcing member 43 in a Y direction after the first reinforcing member is elastically deformed, as shown in FIG. 14A. In this way, the first reinforcing member 43 can be assembled between the first positioning post 51 and the second positioning post 52, and after the assembling, the first reinforcing member 43 is released to recover from elastic deformation and be assembled in place, as shown in FIG. 14B. The first reinforcing member 43 is made of a highly elastic SUS-301EH material, which may effectively form an elastic arm. The first reinforcing member 43 may be further made of metal, a polymer material, an inorganic non-metallic material, or the like other than the SUS-301EH material. When the first reinforcing member is a metal plate, the metal plate may be a stainless steel reinforcing plate or an aluminum foil reinforcing plate. When the first reinforcing member is a polymer plate, the polymer plate may be a polyester reinforcing plate, a polyimide reinforcing plate, a glass fiber reinforcing plate, a polytetrafluoroethylene reinforcing plate, a polycarbonate reinforcing plate, or the like. This is not strictly limited in the examples of this application.

It should be noted that in the foregoing assembly process, the second protruding portion 43b2 is first inserted into the second clamping groove 52a obliquely. In still some examples of this application, the first protruding portion 43a2 may be further first inserted into the first clamping groove 51a obliquely.

Based on the above, the first protruding portion 43a2 is mated with the first positioning post 51 through the first clamping groove 51a, and the second protruding portion 43b2 is mated with the second positioning post 52 through the second clamping groove 52a. In some other examples of this application, a first bump protruding toward the first reinforcing member 43 may be further arranged on a surface of the first protruding portion 43a2 opposite to the second protruding portion 43b2, to limit movement of the first protruding portion 43a2 in a Z direction. A second bump protruding toward the first reinforcing member 43 is arranged on a surface of the second protruding portion 43b2 opposite to the first protruding portion 43a2, to limit movement of the second protruding portion 43b2 in the Z direction. Further, for ease of mounting, a surface on which the first bump first contacts the first protruding portion 43a2 is an inclined surface, or a surface on which the second bump first contacts the second protruding portion 43b2 is an inclined surface.

The first positioning post 51 and the second positioning post 52 are arranged to protrude from an end surface of a shaft cover 31. In still some examples of this application, a mounting groove may be further arranged on the end surface of the shaft cover 31. Clamping grooves or bumps may be provided on opposite groove walls of the mounting groove in a Y direction, to realize a snap fit with two ends of the first reinforcing member 43. The positioning post and the groove wall of the mounting groove may be understood as positioning members, and the clamping groove or the bump may be understood as a clamping structure.

The first reinforcing member 43 has two functions. A first function is to limit movement of a first FPC 41 in the Z direction, and a second function is to mechanically reinforce a local structure of the first FPC 41. However, in the example of this application, the first reinforcing member 43 mainly exists as a limiting member for limiting the movement of the first FPC 41 in the Z direction. It should be noted that the limiting member may be used as partial structure of the first FPC 41, or may exist independently of the first FPC 41. In other words, the limiting member does not belong to the structure of the first FPC 41.

Some examples of this application further disclose an FPC assembly. The assembly includes a positioning mechanism of the foregoing structure, and further includes a base and an FPC. The FPC is arranged on the base through the positioning mechanism. When the FPC is mounted in place through the positioning mechanism, movement of the FPC in an X direction, a Y direction, and a Z direction may be limited. The assembly of the FPC assembly is simplified, and the structure of the FPC assembly is optimized.

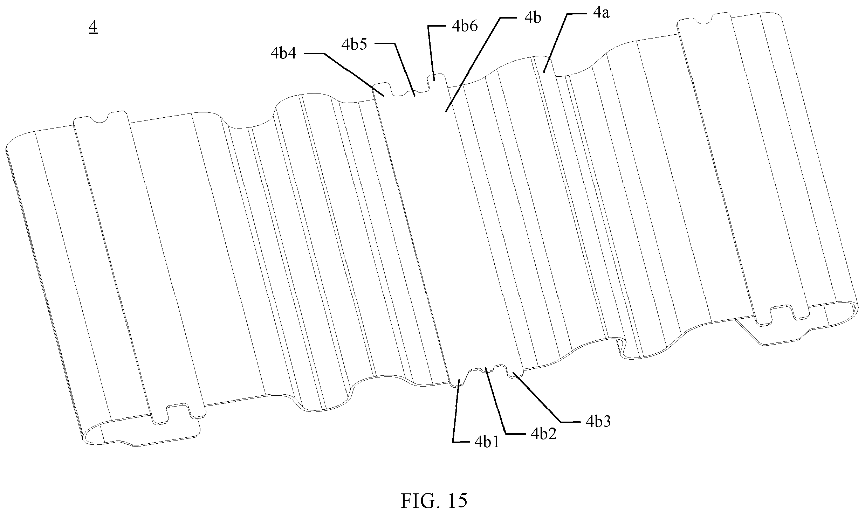

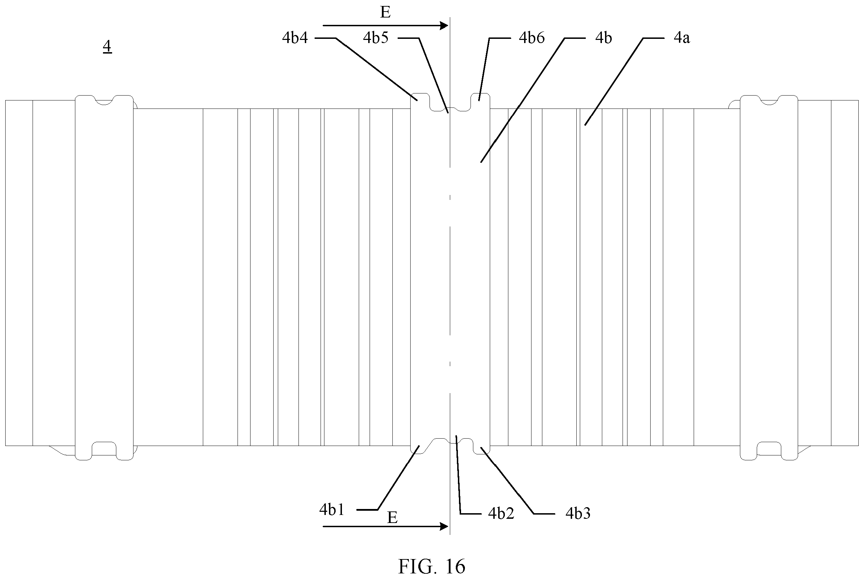

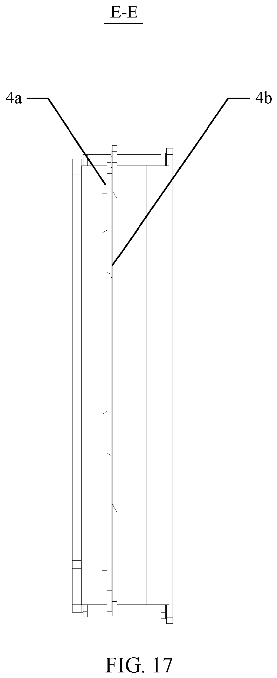

Refer to FIG. 15 to FIG. 17. Some examples of this application further disclose an FPC 4, including a circuit board body 4a, and further including a reinforcing member 4b arranged on a surface of the circuit board body 4a. A first limiting portion 4b1, a first protruding portion 4b2, and a second limiting portion 4b3 are arranged in sequence on a first end of the reinforcing member 4b. The first limiting portion 4b1 and the second limiting portion 4b3 form a first notch. The first protruding portion 4b2 is located in a first notch, and protrudes outward relative to a notch wall of the first notch. A fourth limiting portion 4b4, a second protruding portion 4b5, and a fifth limiting portion 4b6 are arranged in sequence on a second end of the reinforcing member 4b. The fourth limiting portion 4b4 and the fifth limiting portion 4b6 form a second notch. The second protruding portion 43b2 is located in the second notch, and protrudes outward relative to a notch wall of the second notch. Since the foregoing FPC 4 of this application has the above structure, the FPC can be directly snap-fitted between the limiting members of the above positioning mechanism by means of the reinforcing member thereof. The FPC 4 can be fixed without an additional structure, thereby simplifying the mounting of the FPC 4 and reducing the space occupied when the FPC 4 is fixed.

The circuit board body 4a includes at least one substrate layer and at least one wiring layer. The substrate layer includes a polyimide film and/or a polyester film. At least one wiring layer forms a circuit of the FPC 4, and transmission of signals and energy can be implemented through the at least one wiring layer.

The above examples are only the description of the technical solution in which the positioning mechanism is arranged on the shaft cover. It should be noted that the foregoing positioning mechanism may be further arranged on the rotating shaft, on the middle frame, or the like. A specific structure thereof is similar to the technical solution in which the positioning mechanism is arranged on the shaft cover. In this application, the structure such as the shaft cover, the rotating shaft, or the middle frame that needs to be provided with the positioning mechanism may be understood as a base. The base has a function of fixing the FPC while having respective functions.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A positioning mechanism (5), configured to be arranged on a base, wherein the positioning mechanism (5) comprises:
at least two positioning members, arranged at intervals on the base along a length direction of the base; and
a limiting member (43, 44), arranged between the two positioning members, wherein each of the positioning members is provided with a clamping structure, two ends of the limiting member (43, 44) respectively extend to the clamping structures corresponding to the two positioning members, the clamping structure is configured to limit movement of the limiting member (43, 44) in a thickness direction of the base, and a flexible printed circuit (41, 42) is arranged between the limiting member (43, 44) and the base;
wherein the positioning member comprises a positioning post (51, 52, 53, 54), an end of the positioning post (51, 52, 53, 54) is fixed to the base, and an other end of the positioning post (51, 52, 53, 54) is provided with a protrusion extending toward the limiting member;
wherein the clamping structure comprises a clamping groove (51a, 52a), wherein the protrusion, the positioning post (51, 52, 53, 54), and the base constitute the clamping groove, wherein two ends of the limiting member (43, 44) respectively extend into the clamping grooves (51a, 52a) corresponding to the two positioning members.

2. The positioning mechanism according to claim 1,
wherein the clamping groove is provided with opposite side walls (51b, 51c) along a width direction of the base.

3. The positioning mechanism (5) according to claim 2, wherein two end portions of the limiting member (43, 44) along the length direction of the base are each provided with a notch (41a, 41b), and the positioning member corresponding to each notch is at least partially located in the notch (41a, 41b).

4. The positioning mechanism (5) according to claim 3, wherein the end portion of the limiting member (43, 44) extending to the positioning member comprises two limiting portions (43a1, 43b1) arranged at intervals, and the notch is formed in a region between the two limiting portions (43a1, 43b1); and
the notch is provided with a protruding portion protruding toward the clamping groove.

5. The positioning mechanism (5) according to claim 4, wherein a positioning gap (m1) is defined between the notch and a part of the positioning members located in the notch.

6. The positioning mechanism (5) according to claim 5, wherein the positioning gap (m1) ranges from 0.03 mm to 0.1 mm.

7. The positioning mechanism (5) according to claim 6, wherein an avoidance gap (n1) is defined between the protruding portion and the clamping groove in the width direction of the base; further
the avoidance gap (n1) is larger than the positioning gap (m1).

8. The positioning mechanism (5) according to any one of claims 1 to 7, wherein the limiting member (43, 44) comprises a reinforcing member, and the reinforcing member is arranged on a circuit board body of the flexible printed circuit (41, 42).

9. A flexible printed circuit assembly, comprising the positioning mechanism (5) according to any one of claims 1 to 8, and further comprising a base and a flexible printed circuit (41, 42), wherein the flexible printed circuit (41, 42) is arranged on the base through the positioning mechanism (5).

10. A flexible printed circuit (41, 42), comprising a circuit board body, and further comprising at least one reinforcing member (43, 44) according to claim 8, wherein the reinforcing member is arranged on a surface of the circuit board body.

11. An electronic device, comprising a first housing (1), a second housing (2), and a rotating shaft (32) connecting the first housing (1) and the second housing (2), wherein the electronic device further comprises the flexible printed circuit assembly according to claim 9, and two ends of the flexible printed circuit (41, 42) respectively extend into the first housing (1) and the second housing (2).

12. The electronic device according to claim 11, further comprising a shaft cover (31), wherein the shaft cover (31) is arranged on an end surface opposite to a folded region of the rotating shaft (32).

13. The electronic device according to claim 12, wherein at least two positioning members are arranged at intervals on an end surface of the shaft cover (31) close to the rotating shaft (32) along a length direction of the shaft cover (31); or
the limiting member (43, 44) is located on a surface of the flexible printed circuit (41, 42) away from the shaft cover (31).

## Patentansprüche

1. Positionierungsmechanismus (5), der dafür eingerichtet ist, auf einer Basis angeordnet zu sein, wobei der Positionierungsmechanismus (5) Folgendes umfasst:
mindestens zwei Positionierungselemente, die in Abständen an der Basis entlang einer Längsrichtung der Basis angeordnet sind; und
ein Begrenzungselement (43, 44), das zwischen den zwei Positionierungselementen angeordnet ist, wobei jedes der Positionierungselemente mit einer Klemmstruktur versehen ist, zwei Enden des Begrenzungselements (43, 44) sich jeweils zu den den zwei Positionierungselementen entsprechenden Klemmstrukturen erstrecken, die Klemmstruktur dafür eingerichtet ist, eine Bewegung des Begrenzungselements (43, 44) in einer Dickenrichtung der Basis zu begrenzen, und eine flexible gedruckte Schaltung (41, 42) zwischen dem Begrenzungselement (43, 44) und der Basis angeordnet ist;
wobei das Positionierungselement einen Positionierungspfosten (51, 52, 53, 54) umfasst, ein Ende des Positionierungspfostens (51, 52, 53, 54) an der Basis befestigt ist und ein anderes Ende des Positionierungspfostens (51, 52, 53, 54) mit einem Vorsprung versehen ist, der sich zu dem Begrenzungselement hin erstreckt;
wobei die Klemmstruktur eine Klemmnut (51a, 52a) umfasst, wobei der Vorsprung, der Positionierungspfosten (51, 52, 53, 54) und die Basis die Klemmnut bilden, wobei zwei Enden des Begrenzungselements (43, 44) sich jeweils in die Klemmnuten (51a, 52a) erstrecken, die den zwei Positionierungselementen entsprechen.

2. Positionierungsmechanismus nach Anspruch 1,
wobei die Klemmnut mit gegenüberliegenden Seitenwänden (51b, 51c) entlang einer Breitenrichtung der Basis versehen ist.

3. Positionierungsmechanismus (5) nach Anspruch 2, wobei zwei Endabschnitte des Begrenzungselements (43, 44) entlang der Längsrichtung der Basis jeweils mit einer Aussparung (41a, 41b) versehen sind und das jeder Aussparung entsprechende Positionierungselement sich mindestens teilweise in der Aussparung (41a, 41b) befindet.

4. Positionierungsmechanismus (5) nach Anspruch 3, wobei der Endabschnitt des Begrenzungselements (43, 44), der sich zu dem Positionierungselement erstreckt, zwei Begrenzungsabschnitte (43a1, 43b1) umfasst, die in Abständen angeordnet sind, und die Aussparung in einem Bereich zwischen den zwei Begrenzungsabschnitten (43a1, 43b1) ausgebildet ist; und
die Aussparung mit einem vorspringenden Abschnitt versehen ist, der zu der Klemmnut hin vorspringt.

5. Positionierungsmechanismus (5) nach Anspruch 4, wobei ein Positionierungsspalt (m1) zwischen der Aussparung und einem in der Aussparung befindlichen Teil der Positionierungselemente definiert ist.

6. Positionierungsmechanismus (5) nach Anspruch 5, wobei der Positionierungsspalt (m1) im Bereich von 0,03 mm bis 0,1 mm liegt.

7. Positionierungsmechanismus (5) nach Anspruch 6, wobei ein Ausweichspalt (n1) zwischen dem vorspringenden Abschnitt und der Klemmnut in der Breitenrichtung der Basis definiert ist;
wobei ferner der Ausweichspalt (n1) größer ist als der Positionierungsspalt (m1).

8. Positionierungsmechanismus (5) nach einem der Ansprüche 1 bis 7, wobei das Begrenzungselement (43, 44) ein Verstärkungselement umfasst und das Verstärkungselement an einem Leiterplattenkörper der flexiblen gedruckten Schaltung (41, 42) angeordnet ist.

9. Baugruppe einer flexiblen gedruckten Schaltung, umfassend den Positionierungsmechanismus (5) nach einem der Ansprüche 1 bis 8, und ferner umfassend eine Basis und eine flexible gedruckte Schaltung (41, 42), wobei die flexible gedruckte Schaltung (41, 42) durch den Positionierungsmechanismus (5) an der Basis angeordnet ist.

10. Flexible gedruckte Schaltung (41, 42), umfassend einen Leiterplattenkörper, und ferner umfassend mindestens ein Verstärkungselement (43, 44) nach Anspruch 8, wobei das Verstärkungselement auf einer Oberfläche des Leiterplattenkörpers angeordnet ist.

11. Elektronische Vorrichtung, umfassend ein erstes Gehäuse (1), ein zweites Gehäuse (2) und eine Drehwelle (32), die das erste Gehäuse (1) und das zweite Gehäuse (2) verbindet, wobei die elektronische Vorrichtung ferner die Baugruppe einer flexiblen gedruckten Schaltung nach Anspruch 9 umfasst und zwei Enden der flexiblen gedruckten Schaltung (41, 42) sich jeweils in das erste Gehäuse (1) und das zweite Gehäuse (2) erstrecken.

12. Elektronische Vorrichtung nach Anspruch 11, ferner umfassend eine Wellenabdeckung (31), wobei die Wellenabdeckung (31) an einer Endfläche angeordnet ist, die einem Faltbereich der Drehwelle (32) gegenüberliegt.

13. Elektronische Vorrichtung nach Anspruch 12, wobei mindestens zwei Positionierungselemente in Abständen auf einer Endfläche der Wellenabdeckung (31) nahe der Drehwelle (32) entlang einer Längsrichtung der Wellenabdeckung (31) angeordnet sind; oder
sich das Begrenzungselement (43, 44) auf einer von der Wellenabdeckung (31) abgewandten Oberfläche der flexiblen gedruckten Schaltung (41, 42) befindet.

## Revendications

1. Mécanisme de positionnement (5), configuré pour être agencé sur une base, dans lequel le mécanisme de positionnement (5) comprend :
au moins deux éléments de positionnement, agencés à intervalles sur la base le long d'une direction de longueur de la base ; et
un élément de limitation (43, 44), agencé entre les deux éléments de positionnement, dans lequel chacun des éléments de positionnement est pourvu d'une structure de serrage, deux extrémités de l'élément de limitation (43, 44) s'étendent respectivement vers les structures de serrage correspondant aux deux éléments de positionnement, la structure de serrage est configurée pour limiter le déplacement de l'élément de limitation (43, 44) dans une direction d'épaisseur de la base, et un circuit imprimé souple (41, 42) est agencé entre l'élément de limitation (43, 44) et la base ;
dans lequel l'élément de positionnement comprend un montant de positionnement (51, 52, 53, 54), une extrémité du montant de positionnement (51, 52, 53, 54) est fixée à la base, et une autre extrémité du montant de positionnement (51, 52, 53, 54) est pourvue d'une saillie s'étendant vers l'élément de limitation ;
dans lequel la structure de serrage comprend une rainure de serrage (51a, 52a), dans lequel la saillie, le montant de positionnement (51, 52, 53, 54) et la base constituent la rainure de serrage, dans lequel deux extrémités de l'élément de limitation (43, 44) s'étendent respectivement dans les rainures de serrage (51a, 52a) correspondant aux deux éléments de positionnement.

2. Mécanisme de positionnement selon la revendication 1,
dans lequel la rainure de serrage est pourvue de parois latérales opposées (51b, 51c) le long d'une direction de largeur de la base.

3. Mécanisme de positionnement (5) selon la revendication 2, dans lequel deux parties d'extrémité de l'élément de limitation (43, 44) le long de la direction de longueur de la base sont chacune pourvues d'une encoche (41a, 41b), et l'élément de positionnement correspondant à chaque encoche est au moins partiellement situé dans l'encoche (41a, 41b).

4. Mécanisme de positionnement (5) selon la revendication 3, dans lequel la partie d'extrémité de l'élément de limitation (43, 44) s'étendant vers l'élément de positionnement comprend deux parties de limitation (43a1, 43b1) agencées à intervalles, et l'encoche est formée dans une région entre les deux parties de limitation (43a1, 43b1) ; et
l'encoche est pourvue d'une partie saillante faisant saillie vers la rainure de serrage.

5. Mécanisme de positionnement (5) selon la revendication 4, dans lequel un espace de positionnement (m1) est défini entre l'encoche et une partie des éléments de positionnement située dans l'encoche.

6. Mécanisme de positionnement (5) selon la revendication 5, dans lequel l'espace de positionnement (m1) va de 0,03 mm à 0,1 mm.

7. Mécanisme de positionnement (5) selon la revendication 6, dans lequel un espace d'évitement (n1) est défini entre la partie saillante et la rainure de serrage dans la direction de largeur de la base ;
et en outre l'espace d'évitement (n1) est plus grand que l'espace de positionnement (m1).

8. Mécanisme de positionnement (5) selon l'une quelconque des revendications 1 à 7, dans lequel l'élément de limitation (43, 44) comprend un élément de renfort, et l'élément de renfort est agencé sur un corps de carte de circuit imprimé du circuit imprimé souple (41, 42).

9. Ensemble de circuit imprimé souple, comprenant le mécanisme de positionnement (5) selon l'une quelconque des revendications 1 à 8, et comprenant en outre une base et un circuit imprimé souple (41, 42), dans lequel le circuit imprimé souple (41, 42) est agencé sur la base par l'intermédiaire du mécanisme de positionnement (5).

10. Circuit imprimé souple (41, 42), comprenant un corps de carte de circuit imprimé, et comprenant en outre au moins un élément de renfort (43, 44) selon la revendication 8, dans lequel l'élément de renfort est agencé sur une surface du corps de carte de circuit imprimé.

11. Dispositif électronique, comprenant un premier boîtier (1), un deuxième boîtier (2) et un arbre rotatif (32) reliant le premier boîtier (1) et le deuxième boîtier (2), dans lequel le dispositif électronique comprend en outre l'ensemble de circuit imprimé souple selon la revendication 9, et deux extrémités du circuit imprimé souple (41, 42) s'étendent respectivement dans le premier boîtier (1) et le deuxième boîtier (2).

12. Dispositif électronique selon la revendication 11, comprenant en outre un capot d'arbre (31), dans lequel le capot d'arbre (31) est agencé sur une surface d'extrémité en regard d'une zone de pliage de l'arbre rotatif (32).

13. Dispositif électronique selon la revendication 12, dans lequel au moins deux éléments de positionnement sont agencés à intervalles sur une surface d'extrémité du capot d'arbre (31) proche de l'arbre rotatif (32) le long d'une direction de longueur du capot d'arbre (31) ; ou
l'élément de limitation (43, 44) est situé sur une surface du circuit imprimé souple (41, 42) tournée à l'opposé du capot d'arbre (31).
